# EUROPÄISCHE PATENTSCHRIFT

(11) **EP 0 931 184 B1**
(45) Veröffentlichungstag und Bekanntmachung des Hinweises auf die Patenterteilung: **21.03.2001**
(21) Anmeldenummer: 97944717.4
(22) Anmeldetag: 17.09.1997
(51) Int. Cl.: C30B 15/00, C30B 11/00, C30B 29/42

(54) **VERFAHREN ZUR AKTIVEN DEFEKTSTEUERUNG BEI DER ZÜCHTUNG VON GaAs-KRISTALLEN**
PROCESS FOR ACTIVELY CONTROLLING DEFECTS DURING GAAS CRYSTAL GROWTH
PROCEDE DE CONDUCTION LACUNAIRE ACTIVE LORS DE LA CROISSANCE DE CRISTAUX DE GAAS

(30) Priorität: 20.09.1996 DE 19638583
(43) Veröffentlichungstag der Anmeldung: 28.07.1999
(73) Patentinhaber: FORSCHUNGSZENTRUM JÜLICH GMBH, 52425 Jülich (DE)
(72) Erfinder: WENZL, Helmut, D-52428 Jülich (DE); OATES, W., Alan, Leeds LS27 ODR (GB)
(74) Vertreter: Möbus, Steffen
(86) Internationale Anmeldenummer: DE9702082
(87) Internationale Veröffentlichungsnummer: WO9812364

(56) Entgegenhaltungen:
- GB-A- 2 212 796
- PATENT ABSTRACTS OF JAPAN vol. 14, no. 109 (C-0695), 28.Februar 1990 & JP 01 313398 A (FURUKAWA ELECTRIC COMPANY CO LTD), 18.Dezember 1989,
- PATENT ABSTRACTS OF JAPAN vol. 17, no. 436 (C-1096), 12.August 1993 & JP 05 097580 A (NIKKO KYODO CO LTD), 20.April 1993,
- LAMBERT ET AL: "Chemical interactions in GaAs-LEC crystal growth" ADVANCED MATERIALS., Bd. 3, Nr. 9, September 1991, WEINHEIM DE, Seiten 429-435, XP000329345
- NISHIO ET AL.: "Ambient gas constituents and segregation of carbon and boron in LEC GaAs single crystals:the role of water in boric oxide encapsulants" JOURNAL OF CRYSTAL GROWTH., Bd. 134, Nr. 1/2, November 1993, AMSTERDAM NL, Seiten 97-104, XP000415492
- PATENT ABSTRACTS OF JAPAN vol. 18, no. 511 (C-1253), 27.September 1994 & JP 06 172098 A (HITACHI CABLE LTD), 21.Juni 1994,
- PATENT ABSTRACTS OF JAPAN vol. 95, no. 11, 26.Dezember 1995 & JP 07 206588 A (HITACHI CABLE LTD), 8.August 1995,

## Beschreibung

Die vorliegende Erfindung betrifft ein Verfahren und eine Vorrichtung gemäß Oberbegriff von Anspruch 1.

Aus dem derzeitigen Stand der Technik ist bekannt, GaAs-Kristalle vor allem mit dem LE-Czochralski (Liquid Encapsulated Czochralski)- und dem H- und V- LE-Bridgman (Horizontal- und Vertikal- Liquid Encapsulated Bridgman)- Verfahren zu züchten. Dabei werden zwei Klassen von Kristallen angestrebt:
- hochohmige GaAs-Kristalle, die durch Kompensation von As-Antistrukturatomen und von Kohlenstoffdotieratomen im Kristallgitter geprägt sind, und
- gut leitende GaAs-Kristalle, die z. B. mit Silicium dotiert sind.

Hochohmige GaAs-Kristalle stellen besonders hohe Ansprüche an die Festlegung der Konzentration von Eigendefekten und von Fremdatomdefekten. Die Konzentration der Eigendefekte ist dabei durch eine recht gut reproduzierbare Stöchiometrieabweichung mit leichtem As-Überschuß festgelegt. Probleme bereitet aber die präzise Einstellung der erwünschten C-Konzentration und die Unterdrückung der unerwünschten Si-, B- und OKonzentrationen.

Aus GB 2 212 796 A (TOSHIBA KK) 2. August 1989 ist bekannt, daß bei der Züchtung von GaAs-Kristallen ein Monitorgas bzw. wenigstens ein Monitorgas, wie z. B. Wasserstoff, oder ein Dotiergas, wie z. B. CO oder CO₂ kontrolliert in den Kristallzuchtprozeß eingeleitet wird, um dadurch den C-Gehalt des Kristalls zu steuern. Das offenbarte System weist aber nach wie vor zu viele Freiheitsgrade auf, um eine sichere Reproduzierbarkeit eines willkürlich gewählten Arbeitspunktes zu erhalten.

Aus Patent Abstracts of Japan vo. 14, no. 109 (C-0695), 28. Februar 1990 & JP 01 313398 A (FURUKAWA ELECTRIC COMPANY COLTD), 18. Dezember 1989, ist ein Verfahren zur Steuerung der Kohlenstoffverunreinigung eines GaAS-Einkristalls über den Sauerstoffgehalt in der Atmosphäre der Vorrichtung bekannt. Dazu wird der Sauerstoffgehalt <=100 wt.ppm gehalten. Auch unter diesen Bedingungen sind die thermodynamischen Freiheitsgrade des Systems noch nicht ausreichend festgelegt, um reproduzierbaren Arbeitspunkt zu erhalten.

Aus Patent Abstracts of Japan vo. 17, no. 436 (C-1096), 12. August 1993 & JP 05 097580 A (NIKKO KYODO CO LTD), 20. April 1993 ist ein Verfahren zur Steuerung des Kohlenstoffgehaltes eines Kristalls über den Kohlenmonoxidgehalt in der Atmosphäre der Vorrichtung bekannt. Auch mit diesem Verfahren ist die Reproduzierbarkeit des Arbeitspunktes nicht sichergestellt.

Einige bisher im Stand der Technik durchgeführte Korrelatonen zwischen Fremdstoffatomkonzentrationen in GaAs-Kristallen werden im folgenden aufgelistet. Dabei ist auf die thermodynamischen Interpretationen dieser Korrelationen zu achten, da diese Korrelationen durch andere Parameter beeinflußt sein können, die nicht konstant gehalten wurden.
1. C und B nehmen mit Anstieg des H₂O-Gehalts des B₂O₃ ab;
2. C und B nehmen mit Anstieg des H2-Gehalts der Atmosphäre ab;
3. C und B nehmen mit Anstieg des CO-Partialdruckes der Atmosphäre ab;
4. C steigt mit Anstieg des CO-Partialdruckes;
5. Bei konstantem B steigt C um den gleichen Faktor wie der CO-Druck;
6. Die Si-Konzentration steigt mit Anstieg der B-Konzentration;
7. In pBN(pBornitrid)-Tiegeln werden geringe Si und ein wenig erhöhte C-Konzentrationen gefunden, während in Quarz-Tiegeln gewähnlich geringe C- und hohe Si-Konzentrationen gefunden werden;
8. Si und C nehmen ab, wenn Ga2O3 hinzugefügt wird;
9. Si nimmt ab, wenn der Ga2O-Druck erhöht wird;
10. Mit zunehmenden Inertgasdruck steigen B und C an und nimmt O ab, insbesondere wenn der Druck geringer als 1 MPa ist;
11. O nimmt ab, wenn Si hinzugefügt wird, und Si nimmt ab, wenn O der Schmelze zugefügt wird.

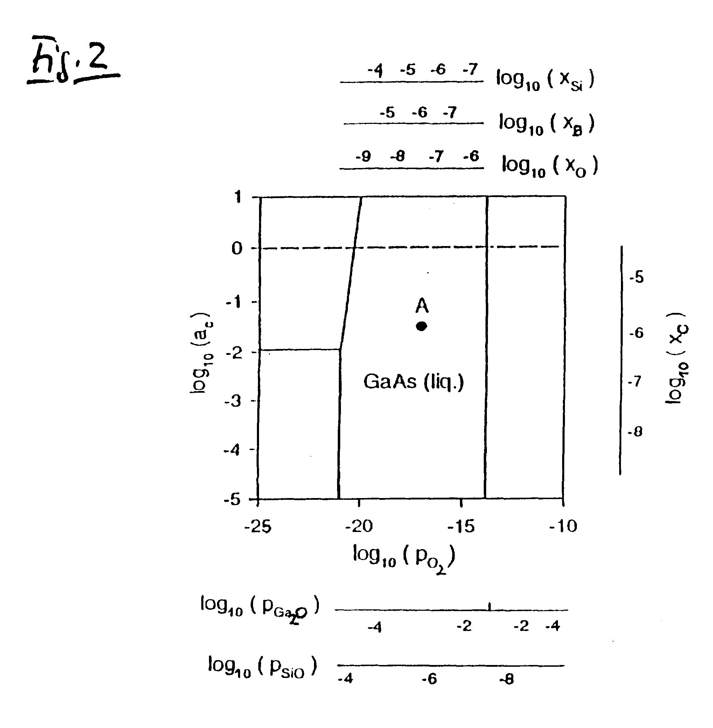

Fig. 2 zeigt diese unterschiedlichen Korrelationsergebnisse des Standes der Technik für pCO als Funktion der C-Konzentration. Es wird deutlich, daß eine komplexe Defektsteuerung erforderlich ist, um optimale Kristalleigenschaften zu erhalten. Die Ausbildung von Galliumarsenid-Kristallen für ein halbleitendes oder hochleitendes Verhalten bei Raumtemperatur basiert auf einer Kombination der Steuerung von Eigendefekt und Fremdatomdotierung. Da während des Kristallwachstums Fremdatome an der Grenzfläche zwischen Flüssig- und Feststoffphase in das Kristall eingefügt werden, ist die Steuerung des Fremdatomgehalts der Flüssigphase von entscheidender Bedeutung, um die gewünschte Kristallqualität zu erhalten. Der nachfolgende Einbau der Störstoffe in den unterschiedlichen Teilen des festen GaAs-Kristalls ist ganz gut bekannt.

Der Erfindung liegt daher die Aufgabe zugrunde, mit einer einfachen Defektsteuerung eine gut definierte und sicher reproduzierbare Fremdatomkonzentration in GaAs-Kristallen zu erzeugen.

Die Aufgabe wird durch die kennzeichnenden Merkmale des neuen Anspruchs 1 gelöst.

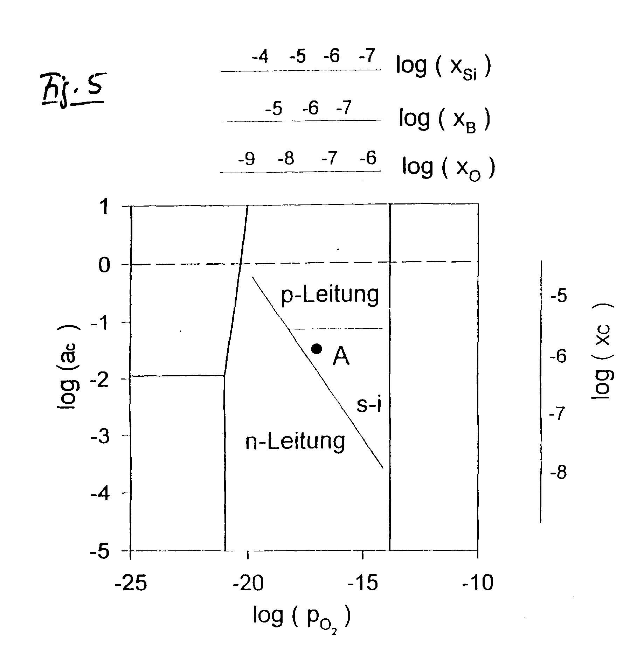

Mit dem erfindungsgemäßen Merkmalen sind die thermodynamischen Verhältnisse bei der Züchtung von GaAs-Kristallen eindeutig zu kontrollieren, so daß auch die Gleichgewichtsdotierung des züchtenden Kristalls in eindeutiger Weise fixiert ist. Darüber hinaus ist mit dem erfindungsgemäßen Verfahren nach Anspruch 1 die C-, O-, Si- und B-Reinheit der Ausgangsprodukte der Kristallzüchtung, vor allem die GaAs, Boroxid und anderer Komponenten, von untergeordneter Bedeutung. Auf diese Weise kann der Fremdatomgehalt der leicht arsenreichen Kristalle so festgelegt werden, daß unabhängig von der Anfangsverunreinigung gezielt p-leitendes, semi-isolierendes (s-i) oder n-leitendes GaAs hergestellt werden kann. Die entsprechende "Betriebsanweisung" für den Kristallzüchter ist in graphisch übersichtlicher Form in Figur 5 dargestellt.

Das neuartige Verfahren eröffnet damit ein ganz neues Potential der Kostenreduzierung durch Verbilligung der

Rohstoffe und durch Verminderung des Kristallausschusses.

Weitere vorteilhafte Merkmale sind im Unteranspruch 2 aufgeführt.

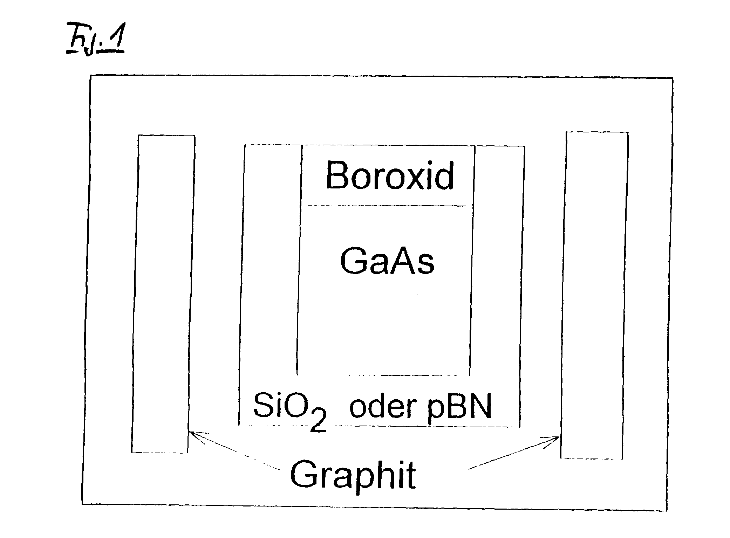

Eine thermodynamische Analyse einer typischen Kristallzuchtanordnung (Fig. 1) zeigt, daß die Konzentration der relevanten Fremdatome in der Kristallzuchtschmelze - damit auch die Konzentration der Dotieratome im Kristall - durch die C-Aktivität und den Sauerstoffpartialdruck festgelegt werden können (Fig. 2).

Es ist wichtig, das Oxidations-/Reduktionsverhalten der verschiedenen Störstoffe im System zu verstehen, da diese den Reststörstoffgehalt der GaAs-Schmelze beeinflussen. Deshalb ist die einfachste Art eines Diagramms zur Darstellung des REDOX-Gleichgewichts die, das Diagramm eines Kohlenstoffpotentials (RTlog (αC)) gegen das Diagramm eines Sauerstoffpotentials (RTlog (pO₂)) aufzutragen.

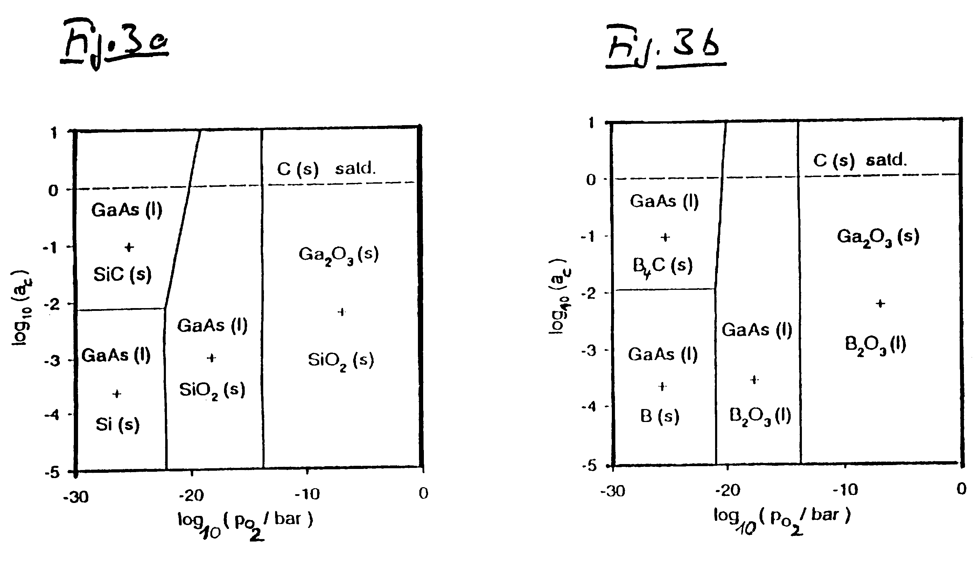

Fig. 3a und 3b zeigen Plots von log₁₀(αC) gegen log₁₀(pO₂) für einige Teile des in Fig. 1 dargestellten Systems bei einer Temperatur von 1513 K, welche der Schmelztemperatur von GaAs entspricht. Mit diesen zwei thermodynamischen Schlüsselparametern, αC und pO_{2,} kann der Stabilitätsbereich der Kristallzuchtschmelze im Beisein des Abdeckmediums, der Tiegelmaterialien und des Graphitheizmediums definiert werden.

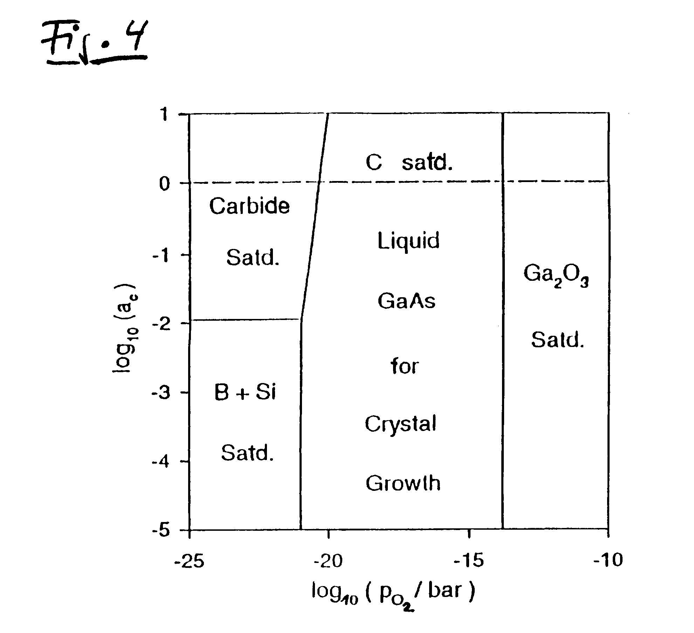

Der Existenzbereich von flüssigem GaAs bei vorliegen von Quarz (Fig. 3a) und bei Vorliegen von Boroxid (Fig. 3b) werden zunächst getrennt analysiert. Anschließend wird die Information aus Fig. 3a mit der aus Fig. 3b zusammengefügt Fig. 4), so daß der Existenzbereich von flüssigem GaAs für ein Kristallwachstum bei Vorliegen von Quarz und Boroxid definiert werden kann. Diese Vorgehensweise ist möglich, da die Grenzen in den Figuren 3a und 3b in etwa gleich verlaufen.

Fig. 4 ist direkt auf die vertikale Bridgman-Technik für ein Kristallwachstum mit offenem Quarztiegel und Boroxidabdeckung gerichtet. Sie kann auch für offene pBN-Tiegel verwendet werden

Die folgenden Punkte zu dem in Fig. 4 gezeigten Stabilitätsbereich von flüssigem GaAS sollten angemerkt werden:
a. er ist rechts begrenzt durch die Oxidation von Ga im flüssigen GaAs zu Ga₂O₃;
b. er ist oben begrenzt durch die Sättigung mit Kohlenstoff (αC = 1). Es muß beachtet werden, daß eine Kohlenstoffabscheidung einen Katalysator benötigt und in Abwesenheit eines geeigneten Katalysators eine Übersättigung möglich ist;
c. links sind B₂O₃ und SiO₂ zu reinem Si und B bei etwa gleichen Sauerstoffdruck reduziert;
d. Silicium- und Borcarbide werden bei niedrigen Sauerstoffpotentialen gebildet, wenn αc ≥ 10⁻² ist.

Auf der Basis der in Fig. 4 definierten Koordinaten des chemischen Potentials können nun die Fremdstörstoffe im flüssigen GaAs, insbesondere C, B, O und Si, betrachtet werden. Es wird davon ausgegangen, daß es im flüssigen GaAs zwischen den Fremdstörstoffen keine Wechselwirkungen gibt. Auch sehr starke Wechselwirkungen würden bei den hier vorliegenden sehr geringen Konzentrationen nur einen vernachlässigbaren Einfluß haben. Durch das Ausschließen von Wechselbeziehungen wird ermöglicht, unabhängige Größenordnungen für die unterschiedlichen Fremdstörstoffe einzusetzen, wie in Fig. 5 dargestellt.

Es sei angenommen, daß die Aktivitäten der beiden Kontrollspezies, C und O₂, am Punkt A in Fig. 5 fixiert werden. Da die Temperatur bei 1513 K konstant gehalten wird, verbleiben im System keine Freiheitsgrade, d. h., die Aktivitäten von Si, B, O und C im flüssigen GaAs sind fixiert. Unter Verwendung der experimentell ermittelten Aktivitätskoeffizienten, die die Aktivitäten und Konzentrationen verbinden, können die Konzentrationen am Punkt A oder an jedem anderen Punkt im Diagramm fixiert werden. Diese Werte sind in graphischer Form durch die verschiedenen, das Diagramm umgebenden Skalen zusammengefaßt.

Die folgenden Anmerkungen dienen dazu, eine Hilfe für die praktische Anwendung von Fig. 5 zu liefern.
1. C-Gehalte in flüssigem GaAs hängen nur von der C-Aktivität ab. Dies ist nicht das gleiche wie proportional zu pCO.
2. Die Skalen der anderen gelösten Fremdstörstoffe Si, O und B sind auf der pO₂-Achse angegeben. Die Konzentration dieser Elemente im flüssigen GaAs hängen ab von
   (a) dem O₂-Druck;
   (b) der Aktivität des relevanten Oxids;
   (c) dem Aktivitätskoefizienten des Fremdstörstoffes in GaAs.
   Is ist zu beachten, daß die Si-, C-, B-iso-Konzentrationslinien vertikal verlaufen, unabhängig vom C-Potential in dem System.
3. Ga₂O- und SiO-Drücke können von den unteren Skalen abgelesen werden. Diese Gasspezies können die Quelle für unerwünschte Ablagerungen an Beobachtungsfenstern des Zuchtsystems sein, da diese bekannterweise bei niedrigeren Temperaturen dissoziieren. Es ist zur beachten, daß der Ga₂O-Druck am rechten Ende des Flüssigzustandbereichs sein Maximum hat, so daß nicht versucht werden sollte, pGa₂O zu veringern, indem die Sauerstoffaktivität bis zu dieser Bereichsgrenze erhöhe wird.

Gegenwärtig werden die thermodynamischen Parameter des Kristallwachsztumsystem nur in rudimentärer Weise gesteuert, meistens über den "Wassergehalt" der Abdeckung aus Boroxid oder in komplizierteren Anordnungen durch Fixieren des CO-Druckes. Es ist äußerst schwer, in solchen statischen Systemen sicher zu sein, wie groß die O- und C-Potentiale sind und das vorliegende Analyseverfahren schlägt Mittel vor, durch welche eine Prozeßsteuerung verbessert werden kann.

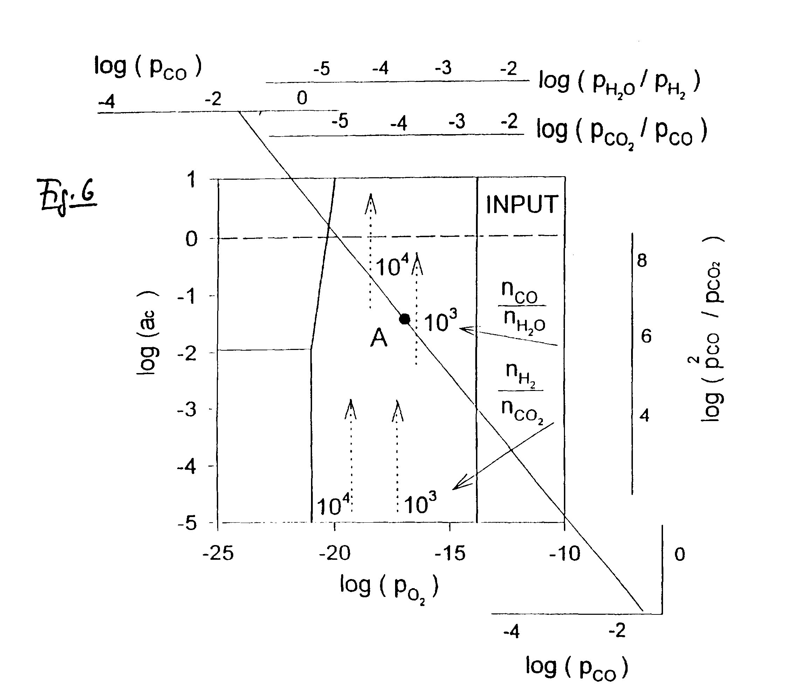

Die C- und O-Potentiale, die für eine optimale Steuerung der C, Si, und B-Gehalte innerhalb des Stabilitätsbereichs der Kristallzuchtschmelze erforderlich sind, können ohne weiteres durch ein Durchströmen mit H₂/CO₂ oder CO/H₂O Gasgemischen erhalten werden, wie in Fig. 6 gezeigt wird. In Fig. 6 sind dem Diagramm aus Fig. 4 verschiedene Skalen hinzugefügt, um die relevanten Gleichgewichts-Gasspezies in dem System graphisch herauslesen zu können, welche gebildet werden, wenn H₂/CO₂ oder CO/H₂O Gasströme mit spezifizierten Verhältnissen und Gesamtdrücken bei 1513 K in den Kristallzuchtkessel eingeleitet werden.

Die punktierten Eingabelinien stehen für zwei sinnvolle Werte, 10³ und 10⁴, des Molekularverhältnisses der eingegebenen Gase. Die entsprechenden CO-Gleichgewichtsdrücke, die im wesentlichen gleich den Gesamtdrücken der eingegebenen CO- und H₂O-Gase im System sind, können durch Verbinden der CO-Skalen an der oberen linken und unteren rechten Ecke der Figur durch gerade Linien für jeden Punkt hergeleitet werden. Die auf den Linien jedes Eingabegemisches dargestellten Pfeile beziehen sich darauf, diese bei unterschiedlichen Werten des Gesamtdruckes des reaktiven Gases zu verwenden. Am Fußende der Pfeile beträgt der Geamtdruck 10-2 bar, wohingegen der gesamte Eingangsdruck am Kopfende 1 bar beträgt.

Es ist zu erkennen, daß die Verwendung von ohne weiteres herzustellenden Gasgemischen gestattet, jedes beliebige C- und O-Potential innerhalb des Stabilitätsbereichs zu erreichen, um somit die Steuerung der gewünschten C, B, Si und C-Gehalte zu ermöglichen.

Mit den Ergebnissen aus den Figuren 5 und 6 ist es nun möglich , die eingangs genannten Korrelationen zu analysieren und verszeckte Parameter aufzudecken, die beim Aufstellen der Korrelationen nicht konstant gehalten wurden. So ist z. B. der Anstieg von pCO allein nicht ausreichend , um eine Änderung in der C-Konzentration vorauszusagen, wenn nicht das Sauerstoff potential konstant gehalten wird. Schwankungen des Sauerstoffpotentials können z. B. unbeabsichtigt durch die Sauerstoffquelle oder durch geringe Mengen Wasserdampf im verwendeten CO-Gas auftreten. B und Si vändern sich immer in die gleiche Richtung, und ein Anstieg von O ist mit einer Abnahme von Si und B korreliert. Dies kann bereits durch Betrachten der Skalen auf der Oberseite von Fig. 5 erkannt werden.

Falls pCO konstant bleibt während sich das Sauerstoffpotential verändert, z. B. durch Verändern des H₂O-Gehalts der Charge, kann aus Fig. 6 ersehen werden, daß B, Si und C sich immer in der gleichen Weise verändern und in einer entgegesetzten Weise zu gelöstem O. Es escheint möglich, daß die Wirkung eines Anstiegs des Inertgasdruckes darin besteht, das O-Potential zu erhöhen und das C-Potential des Systems zu vermindern.

C und B sind grundsätzlich unabhängig voneinander. Der C-Gehalt wird durch das C-Potential und der B-Gehalt durch das O-Potential bestimmt.

## Patentansprüche

1. Verfahren zur aktiven Defektsteuerung bei der Züchtung von GaAs- Kristallen in einem Kristallzuchtkessel, in welchem bei einer konstanten Temperatur durch Einleiten einer definierten Gasströmung, bestehend aus einem Gasgemisch aus H₂/CO₂ oder CO/H₂O, die Konzentration der Eigendefekte und die Konzentration der Fremdatome mittels der C-Aktivität und des Sauerstoffpartialdrucks festgelegt werden, um einen Arbeitspunkt zu definieren,
dadurch gekennzeichnet,
daß die C-Aktivität und der Sauerstoffpartialdruck durch gleichzeitige Bestimmung des Verhältnisses der CO- und CO₂-Drucke und des Gesamtdrucks festgelegt werden, um einen reproduzierbaren Arbeitspunkt zu definieren.

2. Verfahren nach Anspruch 1,
dadurch gekennzeichnet,
daß die definierte Gasströmung im Temperaturbereich der Schmelztemperatur des GaAs (± 20 K) in den Kristallzuchtkessel eingeleitet wird.

## Claims

1. A method of active defect control for growing GaAs crystals in a crystal growing container, wherein by introduction of a defined gas stream, comprised of a gas mixture of H₂/CO₂ or CO/H₂O, at a constant temperature the concentration of the inherent defects and the concentration of the foreign atoms are determined by means of the C activity and the partial pressure of oxygen in order to define an operating point, characterized in that the C activity and the partial pressure of oxygen are determined by simultaneous measurement of the ratio of CO and CO₂ pressures and the total pressure in order to define a reproducible operating point.

2. A method according to claim 1, characterized in that the defined gas stream is introduced into the crystal growing container in a temperature range of the melting temperature of the GaAs (± 20 K).

## Revendications

1. Procédé d'élimination active des défectuosités rencontrées dans la culture de cristaux de GaAs dans un bassin de culture de cristaux, selon lequel on détermine la concentration des défectuosités propres et la concentration des atomes étrangers au moyen de l'activité C et de la pression partielle d'oxygène, ce à température constante, par insufflation d'un écoulement de gaz défini constitué d'un mélange de gaz de H₂/CO₂ ou CO/H₂O, ceci afin de définir un point de travail, caractérisé en ce que l'activité C et la pression partielle d'oxygène sont fixées par détermination simultanée du rapport des pressions de CO et de Co2 et de la pression totale, pour définir un point de travail reproductible.

2. Procédé selon la revendication 1, caractérisé en ce que l'écoulement défini de gaz est insufflé dans le bassin de culture de cristaux dans l'intervalle de température de la température de fusion du GaAs (+/- 20 K).
